(19) Europäisches Patentamt

European Patent Office

Office européen des brevets

(11) **EP 2 348 637 A1**

(12) **EUROPÄISCHE PATENTANMELDUNG**

(43) Veröffentlichungstag:
    **27.07.2011 Patentblatt 2011/30**

(51) Int Cl.:
    *H03K 17/95* (2006.01)  *G01V 3/08* (2006.01)
    *G01D 5/244* (2006.01)  *G01D 5/14* (2006.01)

(21) Anmeldenummer: **11151570.6**

(22) Anmeldetag: **20.01.2011**

(84) Benannte Vertragsstaaten:
    **AL AT BE BG CH CY CZ DE DK EE ES FI FR GB
    GR HR HU IE IS IT LI LT LU LV MC MK MT NL NO
    PL PT RO RS SE SI SK SM TR**
    Benannte Erstreckungsstaaten:
    **BA ME**

(30) Priorität: **21.01.2010 DE 102010001076**

(71) Anmelder: **PMDTechnologies GmbH
    57076 Siegen (DE)**

(72) Erfinder:
    • **Frey, Jochen
      35578, Wetzlar (DE)**
    • **Hoberg, Stefan
      57368, Lennestadt (DE)**

(74) Vertreter: **WSL Patentanwälte
    Kaiser-Friedrich-Ring 98
    65185 Wiesbaden (DE)**

(54) **Induktiver Näherungssensor und Verfahren zur Näherungsdetektion**

(57) Die vorliegende Erfindung betrifft einen induktiven Näherungssensor mit einem Magnetsensor. Um einen induktiven Näherungssensor und ein Verfahren zum Betrieb eines solchen Näherungssensors bereitzustellen, das es ermöglicht, Änderungen des magnetischen Feldes durch die An-oder Abwesenheit eines Targets mit verbesserter Empfindlichkeit zuverlässig zu detektieren, wird erfindungsgemäß vorgeschlagen, daß zusätzlich eine Magnetvorrichtung zur Erzeugung eines mindestens für eine Messperiode reproduzierbaren Magnetfeldes vorgesehen ist, und dass mindestens diese Magnetvorrichtung modulierbar ist.

ohne Fremdfeld    mit Fremdfeld

Figur 3

EP 2 348 637 A1

**Beschreibung**

Die vorliegende Erfindung betrifft einen induktiven Näherungssensor mit einem Magnetsensor.

Ebenso betrifft die vorliegende Erfindung ein Verfahren zur Näherungsmessung mit einem induktivem Näherungssensor, der einen Magnetsensor umfasst.

Als Magnetsensor wird in diesem Zusammenhang ein Sensor angesehen, welcher irgendeinen messbaren magnetfeldabhängigen Parameter aufweist.

Solch ein Magnetsensor kann beispielsweise ein elektrischer Schwingkreis aus Spule und Kondensator, sog. LC-Schwingkreis, ein magnetabhängiger Widerstand (Magnetwiderstand) oder ein Hall-Element sein.

Zum Beispiel werden mit einem Hall-Element durch Ausnutzung des sog. Hall-Effektes magnetische Flussdichten gemessen. Der Hall-Effekt ergibt sich aus der Lorentzkraft, die auf bewegte Ladungen eine senkrecht zur Bewegungsrichtung und senkrecht zum Magnetfeld gerichtete Kraft ausübt. Dieser Effekt wird messbar, wenn zwischen einem ersten Paar elektrischer Anschlüsse eines Hall-Elements ein vorbestimmter Strom fließt und das Hallelement sich in einem Magnetfeld befindet, dass orthogonal zur Stromrichtung verlaufende Komponenten aufweist. Aufgrund des elektrischen Stromes haben die Elektronen im Hallelement im Mittel eine entsprechende Bewegungsrichtung, so dass eine Ablenkung aufgrund der Lorentzkraft in eine Richtung senkrecht zum Stromfluss erfolgt. Hierdurch entsteht eine Spannung, die der Ablenkung durch die Lorentzkraft entgegenwirkt bis sich ein Gleichgewicht einstellt. Diese Gleichgewichtsspannung wird als Hallspannung bezeichnet. Die Hallspannung ist bei konstanter Stromstärke proportional zu der magnetischen Flussdichte, so dass aufgrund der gemessenen Hallspannung eine Aussage bezüglich der magnetischen Flussdichte möglich ist.

Magnetische Näherungssensoren mit einem Hall-Element als Empfänger werden häufig eingesetzt, um die An- bzw. Abwesenheit von Objekten, sog. Targets, anzuzeigen. Damit dies gelingt, müssen die Targets ein eigenes Magnetfeld bzw. ein sekundäres Magnetfeld, beispielsweise ein durch das Target modifiziertes Erdmagnetfeld, aufweisen. Die Anwendungsgebiete für solche induktiven Näherungssensoren sind daher entsprechend eingeschränkt.

Alternative induktive Näherungssensoren sind Sensoren, die ein Magnetfeld in ihrer Umgebung selber erzeugen. Hierzu gehört der oben genannte LC-Schwingkreis, wobei der Schwingkreis in Resonanz schwingt. Als Folge wird in der Umgebung der Spule ein magnetisches Feld erzeugt, das mit der Resonanzfrequenz amplitudenmoduliert ist. Befindet sich ein Target in dem Magnetfeld, so bilden sich in dem Target Wirbelströme aus, die dem Schwingkreis Energie entziehen; der Schwingkreis wird also gedämpft. Ist die Dämpfung hinreichend groß, so wird dies erfasst und digital ausgewertet. Die Dämpfung des LC-Schwingkreises und damit die Entscheidung, ob ein Target in dem Magnetfeld vorhanden ist, ist stark materialabhängig. Für fehlerfreie, gut reproduzierbare Ergebnisse ist es demnach notwendig, eine materialabhängige Detektionsschwelle zu definieren. Dies schränkt die Verwendung eines solchen Sensors stark ein und führt zu einem erhöhten Kalibierungsaufwand bzw. zu einer größeren Fehlerrate bei der Detektion.

Aus dem Stand der Technik ist weiter bekannt, dass ein Magnetwiderstand zur Messung der Magnetfeldstärke eingesetzt werden kann. Magnetwiderstände haben einen elektrischen Widerstand, der sich unter dem Einfluss eines äußeren Magnetfeldes ändert, im allgemeinen mit dem Magnetfeld zunimmt, so dass man von einem gemessenen Widerstandswert die Stärke des Magnetfeldes ableiten kann, in dem der Widerstand sich befindet. Eine spezielle Form von Magnetwiderständen nutzt den sogenannten Riesenmagnetowiderstand. Dabei wird ausgenutzt, dass der elektrische Widerstand in aufeinanderfolgenden, unterschiedlich magnetisierten dünnen Schichten durch die spinabhängige Streuung von Elektronen beeinflusst wird, was zu einer extrem starken Magnetfeldabhängigkeit des Widerstandes führt.

Der magnetfeldabhängige Sensorparameter kann demnach beispielsweise ein elektrischer Widerstand, eine Hallspannung, ein elektrischer Strom, eine elektrische Spannung oder eine Schwingungsfrequenz sein.

Wird, wie bei herkömmlichen Näherungssensoren üblich, die Entscheidung über An- bzw. Abwesenheit eines Targets unmittelbar, d.h. auf Grundlage der Änderung des magnetischen Feldes, getroffen, können durch das Vorhandensein von Fremdfeldern falsche Detektionsergebnisse erzeugt werden. Fremdfelder sind in dem Kontext der vorliegenden Erfindung magnetische Flussdichten, die durch die Umgebung vorgeben sind und die sich mit für eine Messung gezielt erzeugten magnetischen Flussdichten überlagern. Hierzu gehören insbesondere das Erdmagnetfeld, aber auch Magnetfelder größerer Metallteile oder von Dauermagneten oder von elektrischen Strömen hervorgerufene Felder. Typisch für herkömmliche Näherungssensoren ist, dass die Ermittelung einer Feldänderung durch eine einzige Messung vorgenommen wird, die auch ein Mittelwert über mehrere Messungen sein kann.

Weiter gilt, dass je ausgeprägter das Fremdfeld (Rauschsignal) gegenüber einer für Messzwecke erzeugten Änderung der magnetischen Flussdichte (Signal) ist, desto geringer ist der sog. Signal-Rausch-Abstand. Dies führt dazu, dass die Änderung der magnetischen Flussdichte (Signal) von dem Einfluss des Fremdfeldes nicht eindeutig zu unterscheiden ist, was zu fehlerhaften Detektionsergebnissen führen kann.

Vor dem Hintergrund des beschriebenen Standes der Technik ist es daher Aufgabe der vorliegenden Erfindung, einen induktiven Näherungssensor und ein Verfahren zum Betrieb eines solchen Näherungssensors bereitzustellen, das es ermöglicht, Änderungen des magnetischen Feldes durch die An- oder Abwesenheit eines Targets mit verbesserter Empfindlichkeit zuverlässig zu detektieren.

Hinsichtlich der Vorrichtung wird diese Aufgabe dadurch gelöst, dass zusätzlich eine Magnetvorrichtung zur Erzeugung eines mindestens für eine Messperiode reproduzierbaren Magnetfeld vorgesehen ist, und dass mindestens die Magnetvorrichtung modulierbar ist.

Mit modulierbar" ist dabei zunächst gemeint, dass das durch die Magnetvorrichtung erzeugte Magnetfeld gezielt veränderbar ist, beispielsweise mindestens zwei voneinander verschiedene zeitlich konstante oder auch variierende Werte annehmen kann. Dabei soll durch den Begriff "modulierbar" aber auch eine beispielsweise periodische Modulation, etwa in Sinus- oder Rechteckform umfasst sein.

Weiterhin wird diese Aufgabe bzgl. des Verfahrens durch die in den Ansprüchen 9 bis 14 definierten Verfahrensschritte gelöst.

Gemäß einer Ausführungsform ist zweckmäßigerweise vorgesehen, dass der Magnetsensor ein Hall-Element mit einem ersten und zweiten Paar elektrischer Anschlüsse an jeweils gegenüberliegenden Seiten ist, wobei das erste Paar von Anschlüssen mit einer Stromquelle verbindbar und das zweite Paar von Anschlüssen zum Abgreifen einer quer zu der Stromrichtung erzeugten Hallspannung, als Sensorparameter, vorgesehen ist.

In einer weiteren Ausführungsform ist vorgesehen, dass zusätzlich die Stromquelle modulierbar ist.

Die Modulierung der Magnetvorrichtung und ggf. der Stromquelle ermöglichen es, das Nutzsignal des Sensors von überlagerten Störsignalen besser abzutrennen und die Entscheidung bzgl. der Anwesenheit eines Targets allein an Hand des Nutzsignals zu treffen.

Dabei ist im Sinne der vorliegenden Erfindung unter dem Begriff "Messperiode" eine Zeitdauer zu verstehen, während der der modulierte Parameter einen von Null verschiedenen Wert ohne Vorzeichenwechsel hat. Im Fall einer kontinuierlichen periodischen Modulation entspricht die "Messperiode" daher einer Halbperiode des modulierten Parameters.

Stellt die Magnetvorrichtung ein mindestens für eine Messperiode reproduzierbares Magnetfeld mit der magnetischen Flussdichte ($B_S$) bereit, so bilden sich in einem Target mit dessen Bewegung oder der zeitlichen Änderung des Magnetfelds Wirbelströme aus, die eine magnetische Flussdichte ($B_T$) erzeugen. Dabei ist die erzeugte magnetische Flussdichte des Targets entgegen der magnetischen Flussdichte der Magnetvorrichtung gerichtet, so dass die magnetische Flussdichte des Targets die magnetische Flussdichte der Magnetvorrichtung in ihrer Wirkung schwächt. Zusätzlich existiert ein von der Magnetvorrichtung, dem Target und dem Magnetsensor unabhängiges drittes magnetisches Feld ($B_F$), dass als Fremdfeld die Wirkung des ersten und zweiten Magnetfeldes beeinflusst. In der Folge entsteht somit als Überlagerung der drei magnetischen Felder ein resultierendes magnetisches Feld ($B_R = B_S + B_T + B_F$).

Das resultierende magnetische Feld $B_R$ beeinflusst den Sensorparameter bzw. bewirkt, wenn der Magnetsensor ein Hall-Element ist, eine Ablenkung der Elektronen, die zwischen dem ersten Paar elektrischer Anschlüsse des Hall-Elementes fließen, und ruft damit auch die Hallspannung zwischen dem zweiten Paar elektrischer Anschlüsse hervor. Vorteilhaft ist dabei, dass die An- und Abwesenheit auch von solchen Targets aus Metall angezeigt werden kann, die ursprünglich keinen elektrischen Strom tragen oder kein inhärente magnetische Flussdichte aufweisen.

Ein weiterer Vorteil gegenüber Näherungssensoren aus dem Stand der Technik ist, dass mit einem Hall-Element in Kombination mit der Magnetvorrichtung auch eine Hallspannung bei konstanten Magnetfeldern gemessen werden kann. Dies ermöglicht eine dauerhafte Überwachung, ob ein Target in dem Magnetfeld der Magnetvorrichtung mit einer der Änderung des magnetischen Feldes entsprechenden Frequenz bewegt wird. Dies kann beispielsweise zur Drehzahlregelung eingesetzt werden.

Weiter ist die Form des Hall-Elementes besonders bevorzugt rechteckig ausgestaltet. Andere Formen für das Hall-Element sind dabei nicht ausgeschlossen.

Als Material für das Hall-Element kann grundsätzlich jede elektrisch leitfähige Leiterplatte verwendet werden, bevorzugt bieten sich Halbleiter-Materialien mit einer geringen Ladungsträgerdichte an, da bei diesen Materialien die Hallspannung zwischen dem zweiten Paar elektrischer Anschlüsse relativ hoch ist. Besonders bevorzugt wird als Material für das Hall-Element Silizium verwendet.

Bevorzugt ist die Magnetvorrichtung für die Erzeugung einer betragsmäßig konstanten magnetischen Flussdichte ausgelegt. Mit anderen Worten sind die Fluktuationen der magnetischen Flussdichte vernachlässigbar klein, so dass auch bei langen Messperioden die magnetische Flussdichte einen wohldefinierten Wert annimmt. Dabei ist es auch möglich, dass die Richtung der magnetischen Flussdichte geändert wird, vorzugsweise aber nicht deren Betrag.

In einer Ausführungsform weisen die Stromquelle und/oder die Magnetvorrichtung mindestens einen Frequenzgeber zur Modulation mit einem mittelwertfreien Modulationssignal auf. Vorteilhaft ist dabei, dass bei der Verwendung von ein und demselben Frequenzgeber sowohl für die Stromquelle als auch für die Magnetvorrichtung die Korrelation der Schaltzustände exakt aufeinander abgestimmt werden kann. Dies schließt aber nicht aus, dass mehrere Frequenzgeber verwendet werden, die gegebenenfalls entsprechend abzustimmen sind. Die Verwendung von mehreren Frequenzgebern ist auch dann zweckmäßig, wenn die Stromquelle und die Magnetvorrichtung beispielsweise mit unterschiedlichen Modulationssignalen moduliert werden oder wenn die Phasenbeziehung der zwei Modulationssignale verändert werden soll. Selbstverständlich können bei der Verwendung von mehreren Frequenzgebern, die Stromquelle und die Magnetvorrichtung mit dem gleichen Modulationssignal auch mit einer unterschiedlichen Phasenbeziehung zueinander moduliert werden.

Ein mittelwertfreies Modulationssignal ist von Vorteil, da sowohl bei der Modulierung der Stromquelle oder der Magnetvorrichtung nicht der Betrag der Stromstärke bzw. magnetischen Flussdichte beim Übergang von einer zur nächsten Halbperiode geändert wird, sondern lediglich das Vorzeichen. Folglich kommt es zu einer Drehung der Richtung von Strom und magnetischer Flussdichte.

Die Verwendung anderer, beispielsweise nicht mittelwertfreier, Modulationssignale ist davon nicht ausgeschlossen. So werden im Sinne der vorliegenden Erfindung unter dem Begriff der "Modulation" sowohl zeitlich mit einem Modulationssignal korrelierende Ein- und Ausschaltvorgänge verstanden als auch das Beaufschlagen eines Signals mit einem Modulationssignal, welches auch periodisch sein kann.

In einer Ausführungsform ist der Frequenzgeber für die Erzeugung eines Modulationssignals mit einem Rechtecksignal ausgebildet. Ein solches Rechtecksignal kann beispielsweise in einer Halbperiode einen Wert gleich Null und in einer zweiten Halbperiode einen vorbestimmten von Null verschiedenen Wert annehmen. Die Modulierung mit einem solchen Rechtecksignal führt dazu, dass in der ersten Halbperiode das zu modulierende Bauteil, z.B. die Stromquelle oder die Magnetvorrichtung, ausgeschaltet ist, während in der zweiten Halbperiode die Stromquelle oder die Magnetvorrichtung eingeschaltet ist und eine vorbestimmte Stromstärke oder eine vorbestimmte magnetische Flussdichte bereitgestellt wird. Durch die Periodizität des Modulationssignals ist die Folge von Ein-und Ausschaltvorgängen exakt vorgegeben.

In einer weiteren Ausführungsform ist eine Vorrichtung zur Integration der Sensorparameter vorgesehen. Dies ist vorteilhaft um beispielsweise Mittelwertbestimmungen bei Messsignalen mit wechselndem Vorzeichen zu ermöglichen. Mit anderen Worten, es wird das Produkt aus der resultierenden-magnetischen Feldstärke ($B_R$) und beispielsweise, bei Verwendung eines Hall-Elements, dem Strom durch das Hall-Element gebildet, welches anschließend über eine vorbestimmte Zeitspanne integriert wird. Diese Zusammensetzung der zwei mathematischen Operationen Multiplikation bzw. Mischung und Integration wird auch als Korrelation bezeichnet. Durch die Korrelation wird der Einfluss von nicht korrelierenden Magnetfeldern unterdrückt, so dass dann eine zuverlässige Aussage bezüglich der An- bzw. Abwesenheit eines Targets in dem magnetischen Feld der Senderspule getroffen werden kann. Die Integrationszeit kann sich dabei sowohl über zwei einzelne Messperioden, d.h. beispielsweise zwei Halbperioden des Modulationssignals, oder über mehrere Messperioden, d.h. mehrere Halbperioden des Modulationssignals, erstrek-

ken.

In einer Ausführungsform der Erfindung ist die Magnetvorrichtung eine stromdurchflossene Spule. Der Stromfluss durch die Wicklungen der Leiterbahnen, beispielsweise einer Zylinderspule, induziert dabei eine magnetische Flussdichte, deren Richtung von der Stromrichtung und deren Magnetfeldstärke von der Wicklungszahl, Spulenlänge und der Stromstärke abhängt.

In einer weiteren Ausführungsform weist der induktive Näherungssensor eine Vorrichtung zum Speichern und Multiplizieren der Sensorparameter auf, wobei die Vorrichtung vorzugsweise ein Mikrocontroller ist. Dies ist vorteilhaft, um die gemessenen Sensorparameter zeitverzögert auszuwerten, unter Anderem kann so eine Mischung später durchgeführt werden.

Das erfindungsgemäße Verfahren zur Näherungsmessung mit einem erfindungsgemäßen induktiven Näherungssensor weist die Schritte auf:

a) Anordnen des Sensors in einem ersten Abstand zu einem Target.
b) Während einer ersten Messperiode Erzeugen eines ersten Magnetfeldes mit Hilfe der Magnetvorrichtung.
c) Messen eines Sensorparameters in dem Magnetfeld.
d) Während einer zweiten Messperiode Erzeugen eines zweiten Magnetfeldes mit Hilfe der Magnetvorrichtung, welches einen von dem Magnetfeld während der ersten Messperiode abweichenden Mittelwert hat.
e) Messen des Sensorparameters während der zweiten Messperiode in dem zweiten Magnetfeld.
f) Vergleichen der während der ersten und zweiten Messperiode gemessenen Sensorparameter und Erhalten eines ersten Messergebnisses,
g) Anordnen des Näherungssensors in einem zweiten Abstand zu dem Target.
h) Wiederholen der Schritte b) bis f) und Erhalten eines zweiten Messergebnisses.
i) Vergleichen der ersten und zweiten Messergebnisse und daraus Ableiten einer Grenzwertüberschreitung eines vorbestimmten Abstandes zu dem Target während der ersten und/oder zweiten Messperiode.

Bei der Anordnung des Sensors in einem ersten Abstand zu einem Target ist zu beachten, dass entweder das Target oder der Sensor relativ zur Umgebung in Ruhe sein kann, während das jeweils andere bewegbar ist. Es ist auch nicht ausgeschlossen, dass sowohl das Target als auch der Sensor relativ zu der Umgebung und zueinander bewegbar sind. Wird während einer ersten Messperiode ein erstes Magnetfeld mit Hilfe von der Magnetvorrichtung erzeugt, so induziert diese magnetische Flussdichte $B_S$ zunächst in einem magnetischen Target eine materialabhängige magnetische Flussdichte $B_T$, wobei die magnetische Flussdichte des Targets der magnetischen Flussdichte entgegengerichtet ist. Die resultierende magnetische Flussdichte $B_R$ führt zu einer Veränderung des Sensorparameters, wobei das erste Messergebnis als Referenzwert, beispielsweise in einem Mikrocontroller, abgespeichert werden kann. Während einer zweiten Messperiode wird mit Hilfe der Magnetvorrichtung ein zweites Magnetfeld erzeugt, dessen Mittelwert von dem des ersten Magnetfeldes abweicht. Durch Vergleichen der während der ersten und zweiten Messperiode gemessenen Sensorparameter wird ein erstes Messergebnis bereitgestellt. Anschließend kann der Näherungssenor in einem zweiten Abstand zu dem Target angeordnet werden. Ein zweites Messergebnis kann durch die Wiederholung der Schritte b) bis f) bestimmt werden, so dass durch Vergleichen der Ergebnisse ein Ableiten einer Grenzwertüberschreitung eines vorbestimmten Abstandes zu dem Target während der ersten und/oder zweiten Messperiode möglich ist. Wenn das Target irgendeinen Einfluss auf das Magnetfeld hat, so ist dieser abstandsabhängig. Dies führt auch zu einem Unterschied zwischen den ersten und zweiten Messergebnissen, so dass aus diesem Unterschied wiederum ein Rückschluss auf den Abstand zwischen Target und Sensor möglich ist.

Wenn konkrete Messergebnisse, beispielsweise bei Abwesenheit eines Targets und/oder in einem vorgegebenen Grenzabstand zwischen Sensor und Target, gespeichert werden, so ist es auch möglich, durch eine einzige Messung ohne Änderung des Abstandes eine Grenzwertüber- bzw. Unterschreitung festzustellen. Das gespeicherte Messergebnis ist dann im Sinne der Ansprüche das erste Messergebnis.

Zweckmäßigerweise stimmt das zweite Magnetfeld bzgl. Betrag und Zeitverlauf mit dem ersten Magnetfeld überein, hat jedoch das umgekehrte Vorzeichen. Dies ermöglicht eine besonders einfache und elegante Unterdrückung von Fremdfeldeinflüssen.

Zweckmäßigerweise erfolgen Änderungen der Sensorparameter und die Messung der Sensorparameter auf einer Zeitskala, in der die Abstandsänderung zum Target weniger als 0,5% beträgt. Bei einer im Vergleich zu der Messfrequenz relativ langsamen Annäherung erfolgen die Messungen im quasistationären Zustand. D. h. es ist dann ohne weiteres möglich, eine kontinuierliche Annäherung an das Target zu erfassen. Die Modulationsfrequenz ist dementsprechend an die zu erwartende Annäherungsgeschwindigkeit des Targets anzupassen. Typischerweise liegen die Modulationsfrequenzen oberhalb von 1 kHz, so das entsprechend die für eine Messung minimal erforderliche Integrationszeit maximal eine Tausendstel Sekunde beträgt. Ein Annäherungsvorgang zwischen Sensor und Target, der sich im Bereich von 1/100 Sekunde oder mehr abspielt bzw. eine Reaktionszeit von nicht mehr als 1/100 Sekunde erfordert, kann dann problemlos detektiert werden. Vorzugsweise liegen die Modulationsfrequenzen bei mehreren kHz bis MHz.

Gemäß einer Ausführungsform der Erfindung ist es möglich, die Magnetvorrichtung mit einem Rechtecksignal derart zu modulieren, dass in einer Messperiode die magnetische Flussdichte gleich Null und in einer zweiten Messperiode ungleich Null ist. Mit der Magnetvorrichtung kann somit der Zustand "An", d.h. Bereitstellen einer vorbestimmten reproduzierbaren magnetischen Flussdichte, und der Zustand "Aus", d.h. kein Bereitstellen einer magnetischen Flussdichte, realisiert werden. Solche Ein- und Ausschaltzustände können ebenfalls genutzt werden, um den Einfluss des Fremdfeldes zu erfassen und zu kompensieren.

In einem weiteren bevorzugten Verfahren zur Näherungsmessung ist der Magnetsensor eine Hall-Element, wobei die Schritte c) und e) konkretisiert werden durch:

c) Messen der Hallspannung bei einem konstanten zwischen dem ersten Paar elektrischer Anschlüsse fließendem Strom;
e) Messen der Hallspannung während der zweiten Messperiode bei demselben konstanten Strom wie während der ersten Messperiode;

Durch die Änderung des Magnetfeldes ändert sich auch die Hallspannung, die zwischen dem zweiten Paar Anschlüsse gemessen werden kann. Durch Vergleich der während der ersten und zweiten Messperiode gemessenen Hallspannungen wird ein erstes Messergebnis bereitgestellt. Analog zu dem oben beschriebenen Verfahren kann ein zweites Messergebnis durch die Wiederholung der Schritte b) bis f) ermittelt werden, so dass durch Vergleichen der Ergebnisse ein Ableiten einer Grenzwertüberschreitung eines vorbestimmten Abstandes zu dem Target während der ersten und/oder zweiten Messperiode möglich ist.

In einem weiteren Verfahren zur Näherungsmessung mit einem induktiven Näherungssensor ist der Magnetsensor ein Hall-Element und die Schritte c), d) und e) werden folgendermaßen konkretisiert:

c) Messen der Hallspannung bei einem konstanten zwischen dem ersten Paar elektrischer Anschlüsse fließendem Strom;
d) Während einer zweiten Messperiode Erzeugen eines zweiten Magnetfeldes mit Hilfe der Magnetvorrichtung, welches dem Magnetfeld während der ersten Messperiode betragsmäßig entspricht, jedoch umgekehrte Flussrichtung besitzt;
e) Messen der Hallspannung während der zweiten Messperiode bei einem zweiten Strom mit umgekehrtem Vorzeichen, welcher den gleichen betragsmäßigen Mittelwert hat wie während der ersten Messperiode.

Bei diesem Verfahren ist es von Vorteil, dass durch die Modulierung der Stromquelle die Richtung des Stromes in zwei aufeinanderfolgenden Messperioden gedreht wird, die Stromstärke aber denselben Betrag aufweist. Dadurch ist es möglich, bei einem über die Messperioden konstanten aufgeprägten Magnetfeld, der Anteil des Fremdfeldes an der resultierenden magnetischen Flussdichte $B_R$ und damit auch an der Hallspannung herauszurechnen. Dabei kann der Vergleich der Messergebnisse aus unterschiedlichen Messperioden auch eine Integration der Werte beinhalten.

In einem bevorzugten Verfahren zur Näherungsmessung mit einem erfindungsgemäßen Näherungssensor, wobei der Magnetsensor ein Hall-Element ist, werden die Schritte c), d) und e) konkretisiert durch:

c) Messen der Hallspannung bei einem zwischen dem ersten Paar von Anschlüssen fließenden Strom.

d) Während einer zweiten Messperiode Erzeugen eines zweiten Magnetfeldes mit Hilfe der Magnetvorrichtung, welches einen von dem Magnetfeld während der ersten Messperiode abweichenden Mittelwert hat.

e) Messen der Hallspannung während der zweiten Messperiode bei einem zweiten Strom mit umgekehrten Vorzeichen, welcher den gleichen betragsmäßigen Mittelwert hat wie während der ersten Messperiode.

Mit anderen Worten kann in zwei aufeinanderfolgenden Messperioden sowohl die Magnetvorrichtung als auch die Stromquelle derart moduliert werden, dass in zwei aufeinanderfolgenden Messperioden, die Stromrichtung zwischen dem ersten Paar Anschlüsse kommutiert, die Stromstärke betragsmäßig dabei konstant bleibt, und die aufgeprägte magnetische Flussdichte aus- und eingeschaltet oder ebenfalls kommutiert wird.

In einem weiteren Verfahren ist es von Vorteil, dass die Änderung des Magnetfeldes und ggf. des Hallstroms durch eine mittelwertfreie Modulation erfolgt, so dass das erzeugte Magnetfeld bzw. der erzeugte Strom während der ersten Messperiode denselben Mittelwert, jedoch das umgekehrte Vorzeichen wie während der zweiten Messperiode hat und die in den Schritten c) und d) der oben beschriebenen Verfahren gemessenen Hallspannungen ohne Überlagerung eines Fremdfeldes den gleichen Betrag, jedoch das entgegengesetzte Vorzeichen haben.

Durch die zweifache Kommutierung und Integration der Hallspannung erhält man dann ein positives Messsignal, bei dem der Einfluss des Fremdfeldes eliminiert ist.

Weitere Vorteile, Merkmale und Anwendungsmöglichkeiten der vorliegenden Erfindung werden deutlich anhand der folgenden Beschreibung bevorzugter Ausführungsformen sowie der zugehörigen Figuren.

Es zeigen:

Figur 1     ein Zeitdiagramm der Modulationssignale und der Hallspannung aus dem Stand der Technik;

Figur 2     ein Zeitdiagramm der Modulationssignale und der Hallspannung bei Stromkommutierung entsprechend einem ersten Verfahren der vorliegenden Erfindung;

Figur 3     ein Zeitdiagramm der Modulationssignale und der Hallspannung bei Stromkommutierung und mittelwertfreier magnetischer Flussdichte $B_S$ gemäß einem zweiten Verfahren der vorliegenden Erfindung;

Figur 4     ein Zeitdiagramm der Modulationssignals und der Hallspannung, bei der die Mischung, entsprechend einem dritten Verfahren der vorliegenden Erfindung, zeitversetzt durchgeführt wird.

Allen hier dargestellten Figuren ist gemeinsam, dass willkürliche Einheiten gewählt wurden mit denen das Messprinzip veranschaulicht werden soll und die keine Rückschlüsse auf die quantitativen Verhältnisse der gezeigten Ergebnisse zulassen. Für die Beschreibung aller Figuren gilt, dass als Maß für die magnetische Flussdichte des Fremdfeldes "BF" und für die magnetische Flussdichte der Magnetvorrichtung "$B_S$" verwendet wird. Der Strom durch das Hall-Element zwischen dem ersten Paar elektrischer Anschlüsse wird mit "$I_H$" symbolisiert, während die gemessene Hallspannung zwischen dem zweiten Paar elektrischer Anschlüsse mit "$U_H$" abgekürzt wird. "$U_R$" entspricht der resultierenden Hallspannung die durch +/- Gewichtung von $U_H$ generiert wird. Weiter ist in allen Figuren ein Ausschnitt der oben genannten Parameter über 4 Perioden des Modulationssignals gezeigt, wobei je zwei Perioden die Verhältnisse ohne und mit Fremdfeld veranschaulichen.

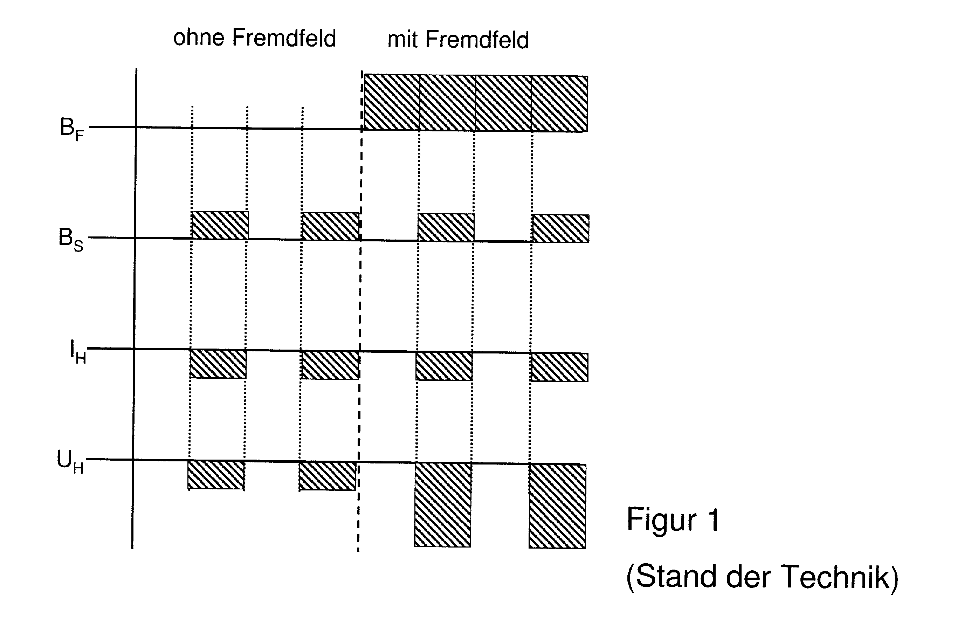

In Figur 1 ist ein Zeitdiagramm der Modulationssignale und der Hallspannung aus dem Stand der Technik abgebildet. Die für den Hall-Effekt maßgebliche physikalische Ursache ist die Lorentz-Kraft $\vec{F} = q(\vec{E} + \vec{v} \times \vec{B})$, die die Ablenkung eines Elektrons in Abhängigkeit eines elektrischen Feldes $\vec{E}$, seiner Geschwindigkeit $\vec{v}$ und der magnetischen Flussdichte $\vec{B}$ beschreibt. Da die elektrische Feldkomponente bei einer magnetischen Feldänderung konstant ist, und in Richtung des Integrationsweges der Hallspannung 0 ist, ist demnach das Vektorprodukt aus Geschwindigkeit und magnetischer Flussdichte für die Lorentz-Kraft ausschlaggebend. Die Hallspannung zwischen dem zweiten Paar elektrischer Anschlüsse des Hall-Elementes lässt sich mit

$$U_H = \int_a^b \vec{E} \cdot d\vec{s} = \int_a^b \frac{\vec{F}}{q} \cdot d\vec{s}$$  berechnen.

Ersichtlich wird aus dem Zusammenhang, dass wenn die Geschwindigkeit eines Elektrons oder die magnetische Flussdichte gleich Null ist, die resultierende Hallspannung gleich Null ist. Dieser Zusammenhang stellt sich auch in Figur 1 dar. In den Halbperioden des Modulationssignals in denen kein Strom zwischen dem ersten Paar elektrischer Anschlüsse des Hall-Elementes fließt, ist die resultierende Hallspannung gleich Null. Unter der Vorraussetzung, dass ein Strom zwischen dem ersten Paar elektrischer Anschlüsse fließt, kann eine resultierende magnetische Flussdichte die Elektronen ablenken und zwischen dem zweiten Paar elektrischer Anschlüsse so eine Hallspannung gemessen werden. Allerdings ist die magnetische Flussdichte die Summe der magnetischen Flussdichten des Fremdfeldes der Magnetvorrichtung und des Targets, was dazu führt, dass in den Halbperioden in denen eine Hallspannung gemessen wird und ein Fremdfeld existiert nicht unterschieden werden kann, welche Anteile an der Hallspannung von der magnetischen Flussdichte des Fremdfeldes (Rauschsignal) und welche von der magnetischen Flussdichte der Magnetvorrichtung und des Targets hervorgerufen werden. Eine zuverlässige Entscheidung bezüglich der An- bzw. Abwesenheit eines Targets sind somit hier nicht möglich.

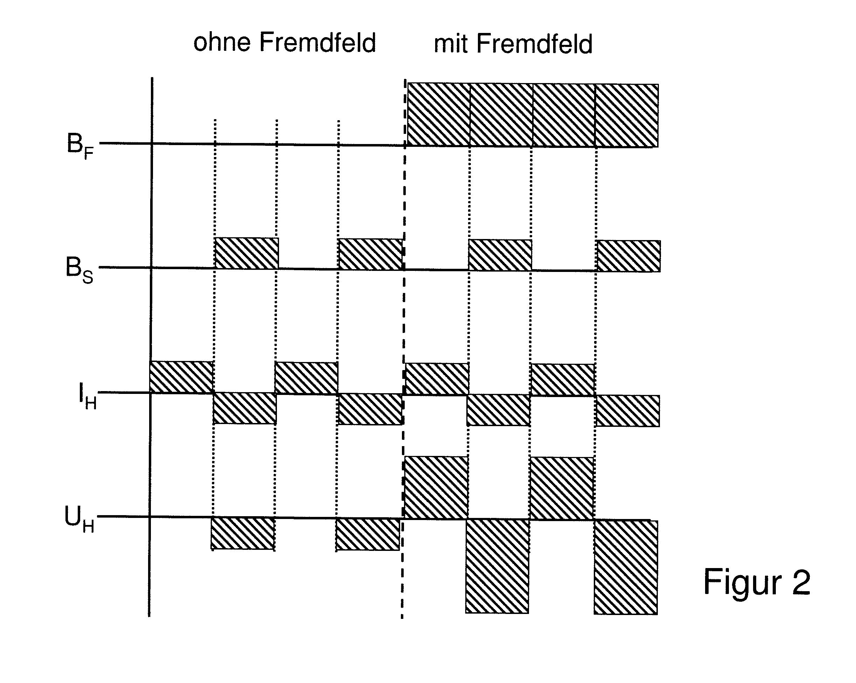

Ein Zeitdiagramm der Modulationssignale und der Hallspannung bei Stromkommutierung entsprechend einem ersten Verfahren der vorliegenden Erfindung ist in Figur 2 gezeigt. Die Magnetvorrichtung ist mit einem ersten Frequenzgeber und einem Rechtecksignal derart moduliert, dass in der ersten Halbperiode des Modulationssignals die magnetische Flussdichte Null ist und in der zweiten Halbperiode des Modulationssignals die magnetische Flussdichte den konstanten Wert annimmt. Die Stromquelle ist dabei mit einem zweiten Frequenzgeber derart mit einem mittelwertfreien Rechtecksignal frequenzmoduliert, dass die Richtung des Stromflusses zwischen dem ersten Paar elektrischer Anschlüsse, in aufeinanderfolgenden Halbperioden des Modulationssignals kommutiert wird. Dabei sind die zwei Frequenzgeber so aufeinander abgestimmt, dass die Modulationssignale in Phase zueinander sind und die Übergänge zwischen den Halbperioden zeitlich miteinander korrelieren.

Die in der ersten Halbperiode gemessene Hallspannung wird von dem Stromfluss und der magnetischen Flussdichte des Fremdfeldes beeinflusst. Ist im idealisierten Fall in diesen Halbperioden auch kein Fremdfeld vorhanden, so ist die gemessen Hallspannung gleich Null. Ist hingegen in den Halbperioden ein Fremdfeld vorhanden, so wird eine Hallspannung gemessen, die nur von der magnetischen Flussdichte des Fremdfeldes abhängt und als Rausch-Signal bezeichnet werden kann.

In den Halbperioden in denen die Magnetvorrichtung die konstante magnetische Flussdichte $B_S$ bereitstellt und die Richtung des Stromflusses zwischen dem ersten Paar elektrischer Anschlüsse des Hall-Elementes kommutiert, hängt die gemessen Hallspannung von der resultierenden magnetischen Flussdichte $B_R$ ab und ändert durch die Kommutierung der Stromrichtung auch das Vorzeichen.

Werden die in den Halbperioden gemessenen Modulationssignale fortlaufend über die zurückliegenden Halbperioden des Modulationssignals der aktuellen Messung integriert, so hat dies den Vorteil, dass der Beitrag des Fremdfeldes an der Hallspannung, der durch die Vergleichsmessung in den Halbperioden, in denen die magnetische Flussdichte $B_S$ gleich Null war, bestimmt wurde, von dem Messsignal subtrahiert wird. Im Mittel ergibt sich ein von der magnetischen Flussdichte des Fremdfeldes unabhängiges Signal. Ein fortlaufender Vergleich des aktuellen Integrationswertes mit einem vorbestimmten Referenzwert führt zur Bereitstellung eines Differenzsignals, mit dessen Hilfe eine zuverlässige Entscheidung bezüglich der An- bzw. Abwesenheit eines Targets möglich ist.

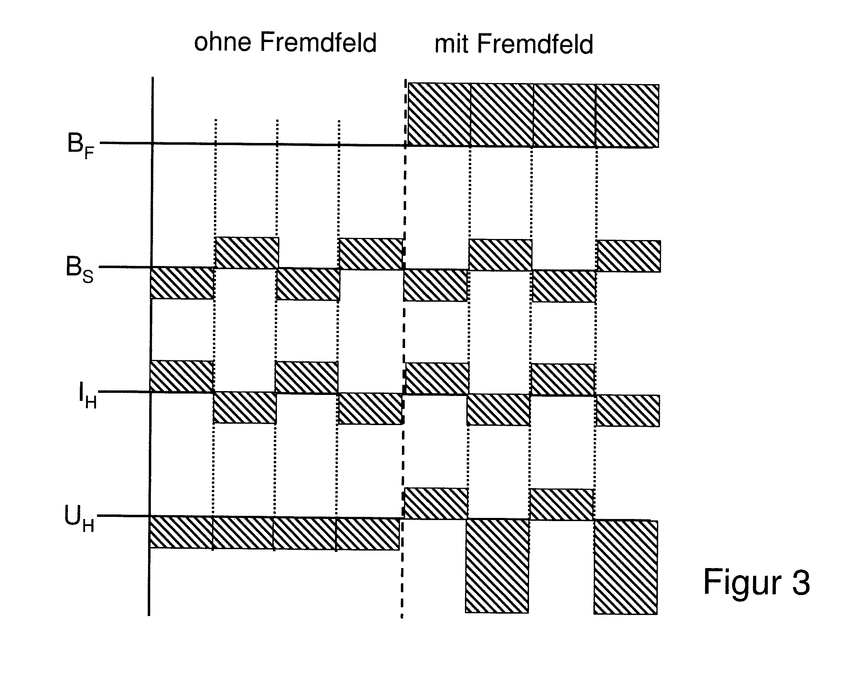

In Figur 3 ist ein Zeitdiagramm der Modulationssignale und der Hallspannung bei Stromkommutierung und mittelwertfreier magnetischer Flussdichte $B_S$ gemäß einem zweiten Verfahren der vorliegenden Erfindung dargestellt. Für den Zeitraum einer Messung wird die Magnetvorrichtung und der Stromfluss zwischen dem ersten Paar elektrischer Anschlüsse des Hall-Elementes derart mit einem Frequenzgeber, beispielsweise mit einem mittelwertfreien Rechtecksignal, moduliert, dass in der ersten Halbperiode des Modulationssignals die magnetische Flussdichte der Magnetvorrichtung in eine erste Richtung weist und der Stromfluss zwischen dem ersten Paar elektrischer Anschlüsse in eine erste Richtung erfolgt. In einer zweiten Halbperiode des Modulationssignals wird sowohl die Richtung der magnetischen Flussdichte der Magnetvorrichtung als auch die des Stromes zwischen dem ersten Paar elektrischer Anschlüsse des Hall-Elementes kommutiert. Dies hat zur Folge, dass bei konstanter magnetischer Flussdichte des Fremdfeldes sich in aufeinanderfolgenden Halbperioden des Modulationssignals die magnetischen Flussdichten von Fremdfeld und Magnetvorrichtung alternierend verstärkend und abschwächend überlagern. Mit der Kommutierung der Stromrichtung wechselt das Vorzeichen der jeweils in den Halbperioden gemessenen Hallspannung, so dass eine fortlaufende Integration der in jeder Halbperiode gemessenen Hallspannungen zu einer Verdoppelung der Sensitivität führt. Der Anteil des Fremdfeldes wird durch die Stromkommutierung und Integration der Hallspannung über mindestens zwei Halbperioden eliminiert. Wird der aktuelle Integrationswert mit einem vorbestimmten Referenzwert fortlaufend verglichen, kann ein Differenzsignal bereitgestellt werden, anhand dessen eine zuverlässige Entscheidung bezüglich der An- bzw. Abwesenheit eines Targets möglich ist.

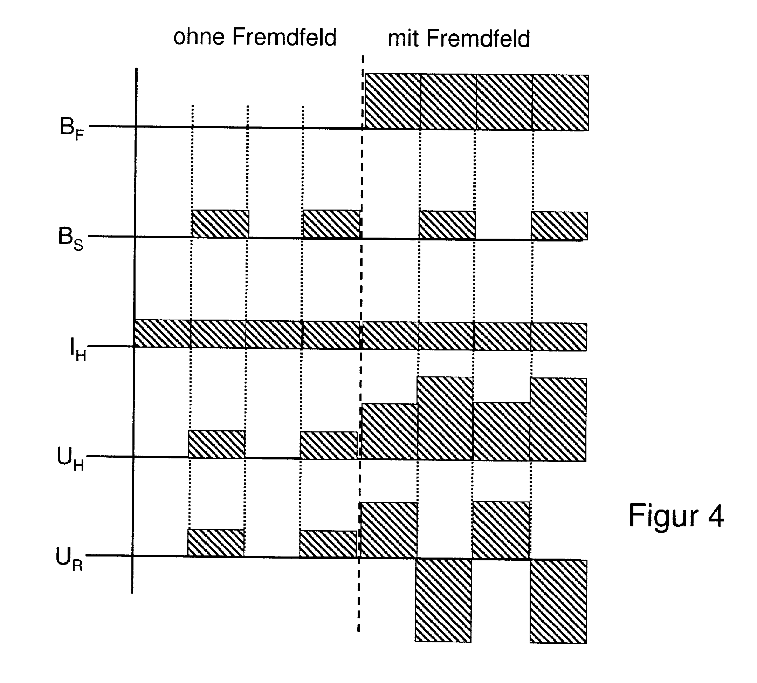

Ein Zeitdiagramm des Modulationssignals und der Hallspannung, bei dem die Mischung, entsprechend einem dritten Verfahren der vorliegenden Erfindung, zeitversetzt durchgeführt wird, ist in Figur 4 gezeigt. Über eine vorbestimmte Messdauer fließt ein Strom zwischen dem ersten Paar elektrischer Anschlüsse in eine Richtung, so dass die Stromrichtung und -stärke über alle Halbperioden des Modulationssignal konstant ist. Die magnetische Flussdichte der Magnetvorrichtung ist hingegen derart moduliert, dass in zwei aufeinanderfolgenden Halbperioden die magnetische Flussdichte alternierend den Wert Null und einen für die Messdauer konstanten Wert annimmt. Messen der Hallspannung zwischen dem zweiten Paar elektrischer Anschlüsse des Hall-Elementes in jeder Halbperiode des Modulationssignals führt, wegen der konstanten Stromrichtung, zu Messwerten mit einem konstanten Vorzeichen. Für eine zeitversetzte Auswertung der Hallspannungen ist es weiter zweckmäßig, die einzelnen Hallspannungen für jede Halbperiode in einer Speichervorrichtung, beispielsweise einem Mikrocontroller, zu speichern.

Zur Durchführung der späteren Korrelation werden die gespeicherten Hallspannungen alternierend mit -1 und +1 multipliziert. Die sich daraus ergebenden resultierenden Hallspannungen $U_R$ werden anschließend über die Messdauer integriert, auch dadurch wird der von dem Fremdfeld beeinflusste Anteil unterdrückt. Ein fortlaufender Vergleich des aktuellen Integrationswertes mit einem vorbestimmten Referenzwert und Bereitstellen eines Differenzsignals erlaubt eine zuverlässige Entscheidung bezüglich der An- bzw. Abwesenheit eines Targets.

Für Zwecke der ursprünglichen Offenbarung wird darauf hingewiesen, dass sämtliche Merkmale, wie sie sich aus der vorliegenden Beschreibung, den Zeichnungen und den abhängigen Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen und die Betonung der Unabhängigkeit der einzelnen Merkmale voneinander wird hier nur der Kürze und der Lesbarkeit der Beschreibung wegen verzichtet.

**Patentansprüche**

1.  Induktiver Näherungssensor mit einem Magnetsensor, **dadurch gekennzeichnet, dass** zusätzlich eine Magnetvorrichtung zur Erzeugung eines mindestens für eine Messperiode reproduzierbaren Magnetfeldes vorgesehen ist, und dass mindestens diese Magnetvorrichtung modulierbar ist.

2.  Induktiver Näherungssensor nach Anspruch 1, **dadurch gekennzeichnet, dass** der Magnetsensor ein Hall-Element mit einem ersten und zweiten Paar elektrischer Anschlüsse an jeweils gegenüberliegenden Seiten ist, wobei das erste Paar von Anschlüssen mit einer Stromquelle verbindbar und das zweite Paar von Anschlüssen zum Abgreifen einer quer zu der Stromrichtung erzeugten Hallspannung, als Sensorparameter, vorgesehen ist.

3.  Induktiver Näherungssensor nach Anspruch 2, **dadurch gekennzeichnet, dass** zusätzlich die Stromquelle modulierbar ist.

4.  Induktiver Näherungssensor nach einem der Ansprüche 1 bis 3, **dadurch gekennzeichnet, dass** die Magnetvorrichtung für die Erzeugung einer betragsmäßig konstanten magnetischen Flussdichte ausgelegt ist.

5.  Induktiver Näherungssensor nach einem der Ansprüche 1 bis 4, **dadurch gekennzeichnet, dass** die Magnetvorrichtung und ggf. die Stromquelle mindestens einen Frequenzgeber zur Modulation mit einem mittelwertfreien Modulationssignal aufweisen.

6.  Induktiver Näherungssensor nach einem der Ansprüche 1 bis 5, **dadurch gekennzeichnet, dass** eine Vorrichtung zur Integration der Sensorparameter vorgesehen ist.

7.  Induktiver Näherungssensor nach einem der Ansprüche 1 bis 6, **dadurch gekennzeichnet, dass** die Magnetvorrichtung eine stromdurchflossene Spule aufweist.

8.  Induktiver Näherungssensor nach einem der Ansprüche 1 bis 7, **dadurch gekennzeichnet, dass** eine Vorrichtung zum Speichern und Multiplizieren der Sensorparameter vorgesehen ist, wobei die Vorrichtung vorzugsweise ein Mikrocontroller ist.

9.  Verfahren zur Näherungsmessung mit einem induktiven Näherungssensor nach einem der Ansprüche 1 bis 8, dass folgende Schritte aufweist,

    a) Anordnen des Sensors in einem ersten Abstand zu einem Target.
    b) Während einer ersten Messperiode Erzeugen eines ersten Magnetfeldes mit Hilfe der Magnetvorrichtung.
    c) Messen eines Sensorparameters in dem Magnetfeld.
    d) Während einer zweiten Messperiode Erzeugen eines zweiten Magnetfeldes mit Hilfe der Magnetvorrichtung, welches einen von dem Magnetfeld während der ersten Messperiode abweichenden Mittelwert hat.
    e) Messen des Sensorparameters während der zweiten Messperiode in dem zweiten Magnetfeld.
    f) Vergleichen der während der ersten und der zweiten Messperiode gemessenen Sensorparameter und Erhalten eines ersten Messergebnisses,
    g) Anordnen des Näherungssensors in einem zweiten Abstand zu dem Target.
    h) Wiederholen der Schritte b) bis f) und Erhalten eines zweiten Messergebnisses.

i) Vergleichen der ersten und zweiten Messergebnisse und daraus Ableiten einer Grenzwertüberschreitung eines vorbestimmten Abstandes zu dem Target während der ersten und/oder zweiten Messperiode.

10. Verfahren zur Näherungsmessung nach Anspruch 9, **dadurch gekennzeichnet, dass** der Magnetsensor ein Hall-Element ist, wobei die Schritte c) und e) konkretisiert werden durch:

c') Messen der Hallspannung bei einem konstanten zwischen dem ersten Paar elektrischer Anschlüsse fließendem Strom;

e') Messen der Hallspannung während der zweiten Messperiode bei demselben konstanten Strom wie während der ersten Messperiode.

11. Verfahren zur Näherungsmessung nach Anspruch 9, **dadurch gekennzeichnet, dass** der Magnetsensor ein Hall-Element ist, wobei die Schritte c), d) und e) zu konkretisieren sind durch:

c') Messen der Hallspannung bei einem konstanten zwischen dem ersten Paar elektrischer Anschlüsse fließendem Strom;

d') Während einer zweiten Messperiode Erzeugen eines zweiten Magnetfeldes mit Hilfe der Magnetvorrichtung, welches dem Magnetfeld während der ersten Messperiode betragsmäßig entspricht, jedoch umgekehrte Flussrichtung besitzt;

e") Messen der Hallspannung während der zweiten Messperiode bei einem zweiten Strom mit umgekehrten Vorzeichen, welcher den gleichen betragsmäßigen Mittelwert hat wie während der ersten Messperiode.

12. Verfahren zur Näherungsmessung nach Anspruch 9, **dadurch gekennzeichnet, dass** der Magentsensor ein Hall-Element ist, wobei die Schritte c), d) und e) zu konkretisieren sind durch:

c"') Messen der Hallspannung bei einem zwischen dem ersten Paar elektrischer Anschlüsse fließendem Strom;

d") Während einer zweiten Messperiode Erzeugen eines zweiten Magnetfeldes mit Hilfe der Magnetvorrichtung, welches einen von dem Magnetfeld während der ersten Messperiode abweichenden Mittelwert hat;

e"') Messen der Hallspannung während der zweiten Messperiode bei einem zweiten Strom mit umgekehrten Vorzeichen, welcher den gleichen betragsmäßigen Mittelwert hat wie während der ersten Messperiode.

13. Verfahren nach einem der Ansprüche 10 bis 12, **dadurch gekennzeichnet, dass** die Änderung des Magnetfeldes und/oder des Hallstroms durch eine mittelwertfreie Modulation erfolgt, so dass das erzeugte Magnetfeld bzw. der erzeugte Strom während der ersten Messperiode denselben Mittelwert, jedoch das umgekehrte Vorzeichen wie während der zweiten Messperiode hat und die in den Schritten c) und d) gemessenen Sensorparameter ohne Überlagerung eines Fremdfeldes den gleichen Betrag, jedoch das entgegengesetzte Vorzeichen haben.

14. Verfahren nach einem der Ansprüche 10 bis 13, **dadurch gekennzeichnet, dass** die Messung der Sensorparameter, sowie die Strom- und Magnetfeldänderungen während einer kontinuierlichen Annäherung an das Target erfolgen, wobei die Strom- oder Magnetfeldänderungen auf einer Zeitskala erfolgen, in der die relative Abstandsänderung zum Target weniger als 0,5% beträgt.

ohne Fremdfeld    mit Fremdfeld

$B_F$

$B_S$

$I_H$

$U_H$

Figur 1

(Stand der Technik)

EP 2 348 637 A1

$B_F$

$B_S$

$I_H$

$U_H$

Figur 2

EP 2 348 637 A1

Figur 3

EP 2 348 637 A1

ohne Fremdfeld    mit Fremdfeld

$B_F$

$B_S$

$I_H$

$U_H$

$U_R$

Figur 4

EP 2 348 637 A1

Europäisches
Patentamt

European
Patent Office

Office européen
des brevets

**EUROPÄISCHER RECHERCHENBERICHT**

Nummer der Anmeldung

EP 11 15 1570

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2005/010543 A1 (KONINKL PHILIPS ELECTRONICS NV [NL]; KAHLMAN JOSEPHUS A H M [NL]; DE B) 3. Februar 2005 (2005-02-03) * Abbildungen 8,12-14,18 * ----- | 1-14 | INV. H03K17/95 G01V3/08 G01D5/244 G01D5/14 |
| X | WO 2007/105143 A2 (KONINKL PHILIPS ELECTRONICS NV [NL]; KAHLMAN JOSEPHUS ARNOLDUS HENR [N) 20. September 2007 (2007-09-20) * Abbildung 5 * ----- | 1-14 | |
| X | WO 2007/132372 A1 (KONINKL PHILIPS ELECTRONICS NV [NL]; DURIC HARIS [NL]; KAHLMAN JOSEPHU) 22. November 2007 (2007-11-22) * Abbildungen 8-10 * ----- | 1-14 | |
| | | | RECHERCHIERTE SACHGEBIETE (IPC) H03K G01R G01V G01D |

Der vorliegende Recherchenbericht wurde für alle Patentansprüche erstellt

| Recherchenort | Abschlußdatum der Recherche | Prüfer |
|---|---|---|
| Den Haag | 20. April 2011 | Simon, Volker |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
............................................................
& : Mitglied der gleichen Patentfamilie, übereinstimmendes
  Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 11 15 1570

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-04-2011

| Im Recherchenbericht angeführtes Patentdokument | Datum der Veröffentlichung | Mitglied(er) der Patentfamilie | Datum der Veröffentlichung |
|---|---|---|---|
| WO 2005010543 A1 | 03-02-2005 | EP 1697755 A1<br>US 2008309329 A1 | 06-09-2006<br>18-12-2008 |
| WO 2007105143 A2 | 20-09-2007 | CN 101400984 A<br>EP 1999452 A2<br>JP 2009530602 T<br>US 2009066318 A1 | 01-04-2009<br>10-12-2008<br>27-08-2009<br>12-03-2009 |
| WO 2007132372 A1 | 22-11-2007 | CN 101438179 A<br>EP 2018574 A1<br>JP 2009536343 T<br>US 2009237844 A1 | 20-05-2009<br>28-01-2009<br>08-10-2009<br>24-09-2009 |

EPO FORM P0461

Für nähere Einzelheiten zu diesem Anhang : siehe Amtsblatt des Europäischen Patentamts, Nr.12/82